# EUROPEAN PATENT SPECIFICATION

(11) **EP 3 232 239 B1**
(45) Date of publication and mention of the grant of the patent: **06.07.2022**
(21) Application number: 17161086.8
(22) Date of filing: 15.03.2017
(51) Int. Cl.: G02B 6/00, H01S 5/022, G02B 6/42, H01S 5/02251, H01S 5/00, F21V 8/00, G02B 6/032, H01S 5/40

(54) **SYSTEM FOR COUPLING A LASER SOURCE IN AN OPTICAL GUIDE**
SYSTEM ZUR KOPPLUNG VON EINER LASERQUELLE IN EINEN OPTISCHEN WELLENLEITER
SYSTEME DE COUPLAGE D'UNE SOURCE LASER DANS UN GUIDE D'ONDE OPTIQUE

(30) Priority: 17.03.2016 IT UA20161794
(43) Date of publication of application: 18.10.2017
(73) Proprietor: Lyocon S.r.l., 20019 Settimo Milanese (MI) (IT)
(72) Inventor: ZANZOLA, Paola, 20019 SETTIMO MILANESE (MI) (IT); SALA, Alessandro, 20019 SETTIMO MILANESE (MI) (IT)
(74) Representative: Colombo, Stefano Paolo

(56) References cited:
- CN-A- 1 116 739
- JP-A- 2006 066 800
- US-A- 4 714 829
- US-A- 4 927 231
- US-A- 5 333 227
- US-A- 5 493 629
- US-A1- 2011 103 409
- US-A1- 2014 071 406

## Description

The present invention relates in general to the field of semiconductor laser sources (or laser diodes). More particularly, the present invention relates to a system for coupling a medium-high power semiconductor laser source, in a liquid optical fiber.

As is known, many industrial and aesthetic-medical applications, such as laser hair removal, require the use of a medium-high power semiconductor laser source. Typically, a medium-high power laser diode emits radiation having power of between a few tens and a few thousands of Watts. Furthermore, for the abovementioned applications, it is typically required that the beam emitted by the laser source has appropriate homogeneity requirements. As is known, however, the beam quality, or brightness, and the divergence of the beam emitted by a high-power laser diode may also be highly asymmetrical along the main transverse directions of the device (horizontal and vertical). Furthermore, the use of high-power laser diodes requires, typically, driving using high currents and high working voltages, as well as the use of a cooling liquid for cooling.

A medium-high power laser diode for industrial and aesthetic-medical applications typically comprises a plurality of laser emitters arranged side-by-side in one direction, typically the horizontal axis, so as to form a so-called laser bar. These types of devices are typically capable of supplying power of several tens or hundreds of Watts. Laser diodes capable of supplying even greater amounts of power (several hundreds or thousands of Watts) may comprise a plurality of laser bars arranged in a stack, i.e. superimposed along the vertical axis to form a so-called laser stack. The single emitter for a medium-high power laser diode typically has a rectangular cross-section with a vertical dimension of a few µm and horizontal dimension of a few tens or hundreds of µm, up to a maximum of about 200 µm. As is known, the vertical and horizontal axes of the individual emitter are also called fast axis and slow axis, respectively. Along the fast axis the laser beam is typically quasi-single mode, i.e. it has a very high beam quality with a beam quality factor, M², which is approximately unitary, but the divergence is very high, typically between 30° and 40° FWHM. Along the slow axis the beam has a rather poor quality with a beam quality factor, M², of between about 20 and about 40, and the divergence is typically between 6° and 14° FWHM.

Typically a laser bar has a length of about 10 mm. The number and the spatial density (or fill factor, equal to the ratio between the width of the single emitter and the spacing between the emitters) of emitters in a laser bar varies depending on certain properties of the device, such as for instance the power, the operating mode (e.g. continuous wave, "CW", or quasi-CW, "QCW") and the cooling system (e.g. active or passive). A laser stack is formed by a minimum of two laser bars up to a maximum of 20-25 laser bars stacked along the fast axis, along which the spacing between the laser bars may vary from a minimum of a few hundreds of µm up to a maximum of about 1.8 - 2 mm.

Laser stacks operating in CW mode may comprise, for instance, laser bars with 19-45 emitters per bar and a spatial density per bar of between about 20% and about 50%. The laser bars may be, for example, spaced at about 1.6 - 2 mm from each other and the emitters at about 200 -500 µm. Such a device is typically cooled with cooling liquid.

Laser stacks operating in QCW mode may comprise, for instance, laser bars with 25-70 emitters per bar and a spatial density per bar of between about 50% and about 90%. The emitters may be spaced for example at about 200 µm from each other. In this case the spacing between the bars may be very small.

In general, the quality of the beam emitted by a medium-high power laser diode deteriorates as the number of emitters per bar, the spatial density of each bar and the number of bars of a laser stack increase.

As is known, the radiation emitted by a medium-high power laser diode may be coupled in an optical fiber in order to, on the one hand, arrange the laser diode in a remote position with respect to the application area and, on the other hand, to provide a homogeneous laser beam in the proximity of the application area. Arranging the laser diode in a remote position with respect to the application area allows the laser diode to be kept close to the electrical power supply rack and to any cooling device. In this way it is possible to limit the length of the power supply cables and the electrical connections and of a possible hydraulic circuit, thus limiting the voltage drop that is generated along the same cables and reducing dispersions. Moreover, the devices necessary for powering and cooling a medium-high power laser diode are typically bulky and often noisy, and often there is not enough space in the application area to accommodate a suitable cooling and power supply system. Furthermore, the use of a cooling fluid, whether air or a liquid, involves the need for suitable maintenance of the cooling system, management of which in the application area typically is preferably to be avoided.

As is known, an optical fiber is an optical guide formed by a core with a high refractive index, capable of guiding the light radiation by means of total internal reflection, and by a cladding, surrounding the core, with a lower refractive index. Core and cladding are typically made of glasslike material.

Implementing the coupling in a glass optical fiber of a medium-high power laser diode, for example a laser stack operating in CW mode, is typically very complex, bulky and expensive. In fact, glass optical fibers have certain limitations that do not allow an efficient coupling. In a glass optical fiber the core diameter is typically limited to a maximum value of about 1.5 mm, beyond which the fiber is no longer flexible, and the numerical aperture (NA) is typically limited to a value of 0.22 (the maximum value is 0.39). For an optical fiber, the beam parameter product (BPP) which, as is known, is obtained by multiplying the half-diameter of the core by the numerical aperture, is an invariant of the propagation and provides an indication of the so-called acceptance of the optical fiber in respect of a laser beam: the lower the BPP, the higher the quality of the beam must be, while the higher the BPP, the poorer the quality of the beam may be. An optical fiber, as is known, can couple efficiently only laser beams having a BPP (defined by the product of the half-diameter multiplied by the divergence half-angle of the beam) which is less than or equal to that of the fiber itself. However, as already mentioned above, the quality of the beam emitted by a medium-high power laser, for example operating in CW mode, is poor, due to the fact that there are often a certain number of laser bars comprising, for instance, 45 emitters each.

For example, a laser stack device is considered, made up of 8 laser bars spaced at 1.8 mm from each other, each laser bar comprising 49 emitters with a transverse dimension of 100 µm. The BPP of the single emitter along the slow axis is comprised between about 4 and 5 and the BPP of the single laser bar, along the same axis, is equal to about 250. Along the fast axis instead the BPP of the individual emitter is between about 1 and 2. A glass optical fiber with maximum diameter of 1.5 mm and numerical aperture equal to 0.22 has a BPP equal to about 165. In this case the fiber cannot effectively couple the beam of the laser stack and not even the beam of a single laser bar.

As is known, there are optical systems for transformation of the laser beam, that is which allow spatial transformation of the optical properties of a laser beam to match these properties with those of a glass optical fiber. For example optical systems for transformation of the laser beam are known, these consisting of so-called micro-optics which each act on a single laser emitter. Some examples of such systems are described in US 6,471,372, US 7,830,608 and EP 1 059 713. These systems require adequate, complex and expensive instrumentation and generate a loss of coupling efficiency between a laser diode and an optical fiber that is significant, typically between 12% and 30%. Such a loss can cause overheating and/or back-reflections. In addition, in the current state of the art, micro-optics systems are not commercially available for all types of high-power laser diodes, for example, they are not available for high-power laser diodes operating with a high duty cycle or in CW mode, due to the optical and geometric characteristics which these devices have, as described above. In particular, micro-optics systems are not available commercially for high-power laser diodes having a high spatial density of emitters and/or emitters with high width and/or bars spaced at less than 2 mm from each other.

It is also known to use, for coupling a laser beam with high BPP in an optical fiber, a so-called fiber bundle, i.e. a bundle of optical fibers grouped together to form a single cable. However, the cladding that surrounds each single optical fiber and the space that is created between one fiber and the other do not guide the radiation and they thus constitute a high loss element in the system. Devices which use the fiber bundle are thus inadequate for use with high-power laser diodes because the power loss would be unacceptable. In addition, the fiber bundle has a non-homogeneous cross-sectional spatial profile. This lack of homogeneity could make a system using the fiber bundle not suitable for some types of industrial and aesthetic-medical applications.

Finally, beam transformation systems suitable for laser stacks are not known - only for a single laser bar. In particular, optical systems for transformation of the laser beam suitable for laser bars consisting of more than 25 emitters are known in the state of the art, but they have some limitations with regard to the spatial features which are typically required in a medium-high power laser, such as limitations relating to the spatial density of the emitters.

US 2014/071406 A1 discloses two short lists, one list defining light sources, among them 2D-arrays of laser diodes, for example laser bars, the second list defining delivery systems, which comprise (among others) a liquid light guide. Details of the liquid light guide are not disclosed in US 2014/071406.

The object of the present invention is therefore to provide a system for coupling a medium-high power laser diode in an optical guide, which solves at least one of the abovementioned problems.

In particular, an object of the present invention is to provide a system for coupling any medium-high power laser diode in an optical guide, which allows minimization of losses and at the same time requires less complex and costly instrumentation than, for example, systems with micro-optics, while also ensuring the homogeneity of the beam.

In the following description and in the claims, the expression "medium-high power laser diode" will indicate a laser diode suitable for emitting a radiation having a power comprised between few tens and few thousands of Watts.

In particular, the expression "medium-high power laser diode" will indicate a laser diode that, in the CW mode, is suitable for emitting an average power comprised between about 50 W and about 2000 W, more in particular an average power comprised between about 300 W and 1000 W.

Moreover, the expression "medium-high power laser diode" will indicate a laser diode that, in the QCW mode, is suitable for emitting a radiation having a peak power comprised between about 500 W and about 8000 W, more in particular a peak power comprised between about 1000 W and about 4000 W.

The power values mentioned above are intended to be measured with a power meter or an energy meter of commercial type.

According to the present invention, these and other objects are achieved by a system as defined in claim 1. As is known, a liquid optical fiber or guide consists of a homogeneous liquid core surrounded by a cladding of polymeric material. As will be explained in greater detail here below in the description, a liquid optical fiber with the properties mentioned above has BPP high enough to be able to couple efficiently, with simple and robust beam conditioning optical systems, a beam emitted by any high-power laser diode. Furthermore, the spatial profile of the beam transmitted by a liquid optical fiber is extremely homogeneous since the fiber does not have discontinuities.

Preferably, the medium-high power laser diode is suitable for emitting a radiation having an average power comprised between about 50 W and about 2000 W in CW mode. More preferably, the medium-high power laser diode is suitable for emitting a radiation having an average power comprised between about 300 W and about 1000 W in CW mode.

Moreover, preferably, the medium-high power laser diode is suitable for emitting a radiation having a peak power comprised between about 500 W and about 8000 W in QCW mode. More preferably, the medium-high power laser diode is suitable for emitting a radiation having a peak power comprised between about 1000 W and about 4000 W in QCW mode.

The medium-high power laser diode comprises at least two laser bars arranged in a stack, each laser bar comprising a plurality of laser emitters arranged side by side along a direction so as to form the laser bar.

According to embodiments of the present invention, each of the at least two laser bars has a length of about 10 mm, and the spacing between the emitters of the at least two laser bars is about 200 µm, 400 µm or 500 µm. Preferably, the spatial density of each laser bar varies from a minimum of about 20% to a maximum of about 90%.

The optical fiber comprises a liquid core and a cladding of polymeric material.

The core of the optical fiber has a diameter of between about 2 mm and about 8 mm and the optical fiber has a numerical aperture of between about 0.3 and about 0.65.

More preferably, the optical fiber has a core diameter of between about 3 mm and 5 mm and a numerical aperture of between about 0.3 and about 0.65.

According to advantageous embodiments of the invention, the liquid core is sealed by means of glass bars, the bars being coated by the polymeric material of the cladding, the polymeric material being in turn coated by a metal coating at one end of said optical fiber, wherein a terminal part of a glass bar at said end protrudes lengthwise with respect to the metal coating.

Preferably the terminal part of the glass bar at the end of the optical fiber protrudes with respect to the metal coating by a length of between about 3 mm and about 10 mm.

Preferably the coupling optics comprises cylindrical fast-axis collimation lenses in the proximity of the laser diode.

Preferably the coupling optics comprises an aspherical lens and/or a convex lens of the spherical type and/or at least two cylindrical lenses.

According to embodiments of the present invention, the coupling optics comprises one or more mirrors and/or prisms.

According to other embodiments of the present invention, the coupling optics comprises optics of the achromatic type.

According to a second aspect an apparatus is provided for laser hair removal comprising a system for coupling a medium-high power laser diode in an optical guide as set forth above.

The present invention will be illustrated in greater detail with reference to the accompanying drawings, provided by way of a nonlimiting example, in which:
- Figure 1 schematically shows a system for coupling a medium-high power laser diode, in an optical guide according to an embodiment of the present invention;
- Figures 2a and 2b are respectively an axonometric view and a cross-sectional view of the terminal part of an optical guide according to embodiments of the present invention; and
- Figure 3 schematically shows a laser diode and a collimating system according to an embodiment of the present invention.

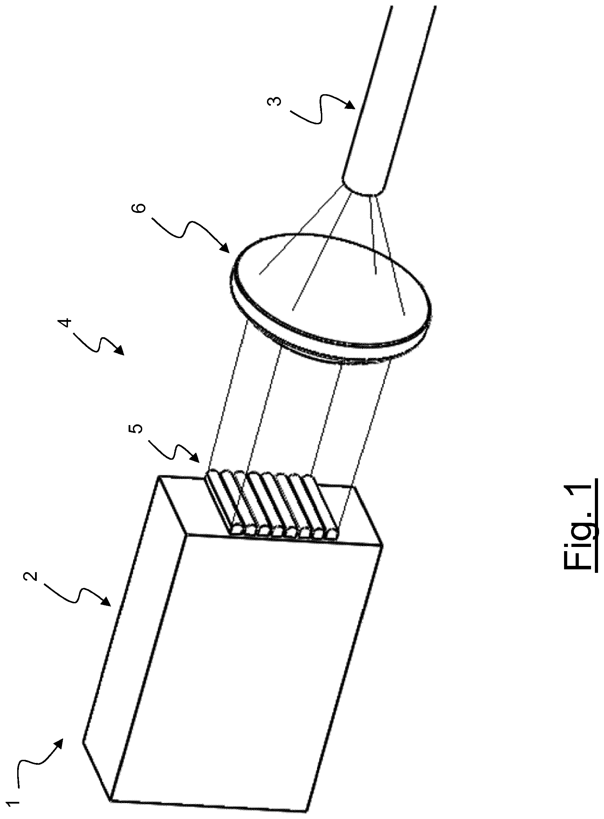

Figure 1 schematically shows a system 1 for coupling a laser diode 2, which is a medium-high power laser diode, in an optical fiber 3, according to embodiments of the present invention.

The system 1 comprises a medium-high power laser diode 2. The laser diode 2 is a laser stack comprising at least two laser bars. Each laser bar may be about 10 mm long and the spacing between the emitters of each laser bar may be 200 µm, 400 µm or 500 µm. The size of each emitter may for instance vary from a minimum value of about 100 µm up to a maximum value of about 200 µm. Each laser bar may comprise, for example, 19, 24, 49 or 70 emitters. The spatial density or fill factor of the considered laser stack may vary from a minimum of about 20% up to a maximum of about 90%.

The system 1 also comprises an optical fiber 3. The optical fiber 3 is preferably a liquid optical fiber. The optical fiber 3 preferably has a core surrounded by a cladding. The diameter of the core is preferably of between about 2 mm and about 8 mm. The fiber 3 preferably has a numerical aperture of between about 0.3 and about 0.65, i.e. a BPP greater than about 300 and less than about 2600. More preferably, the optical fiber 3 has core diameter of between about 3 mm and 5 mm and numerical aperture of between about 0.3 and 0.65. For example, the optical fiber 3 may have a core diameter of 3 mm and numerical aperture of 0.54. One such fiber is, for example, available commercially and produced by the company Lumatec GmbH. This fiber has a BPP of about 810.

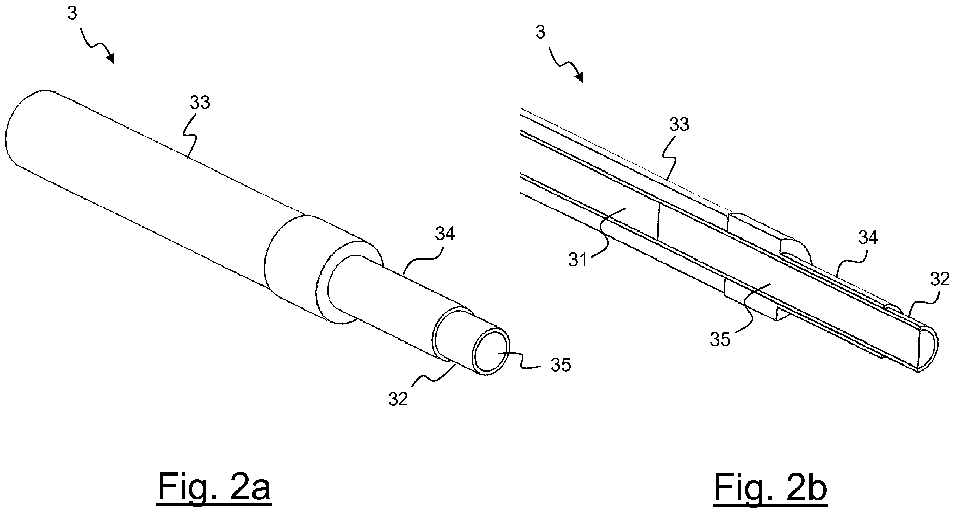

Figures 2a and 2b show in schematic form the connectorized terminal part, or end, of the optical fiber 3 according to the present invention. As already mentioned previously, the optical fiber 3 comprises a liquid core 31 surrounded by a cladding 32 of polymeric material. Figures 2a and 2b also show an outer coating 33 of the fiber 3 and a metal coating 34 which acts as connector. The liquid of the core is sealed with the aid of glass bars 35 (for example, two bars, one for each end of the fiber 3) having a length of between a few mm and a few tens of mm, for example, between about 20 mm and 50 mm. Such glass bars give rigidity to the terminal parts of the optical fiber 3 and also serve as connectors. The glass bars are coated with the same polymeric material as the cladding (in order to guide the radiation transmitted in the fiber) which in turn is inserted in the metal coating 34 which acts as a structure for the connector of the optical fiber 3.

According to advantageous embodiments of the present invention, the glass bars 35 that seal the core 31 of the optical fiber 3 protrude lengthwise beyond the metal coating 34. In particular, according to embodiments of the present invention, at least one glass bar 35 (for example, the glass bar positioned at the connectorized end where the beam is output from the optical fiber 3) protrudes with respect to the metal coating 34 by a length of between about 3 mm and about 10 mm. The terminal part of each bar 35 which protrudes with respect to the metal coating 34 may be coated with the polymeric material of the cladding. According to other embodiments of the present invention, the terminal part of each bar 35 which protrudes with respect to the metal coating 34 is not coated with the polymeric material of the cladding. The fact that at least one bar protrudes with respect to the metal coating advantageously allows certain problems associated with possible losses of power at the edge of the bars to be avoided. In fact, in the case where there are power losses at the input/output interfaces of the optical fiber, the dispersed power would act on the metal coating of the connectors, causing local overheating. In this case, if the temperature of the metal connector should be too high, the polymeric coating and therefore the cladding which is in contact with the connector could suffer damage, thereby adversely affecting the guiding properties of the optical fiber in the proximity of the damaged part. The length of the protruding part is advantageously such that any power dispersed at the input/output interface of the fiber no longer acts on the metal coating, thus allowing overheating of the connectors and damage to the polymeric coating to be avoided. The radiation dispersed on the protruding parts may be advantageously directed onto a heat sink external to the fiber and physically separated from it, so as to be correctly evacuated.

The system 1 also comprises coupling optics 4 suitable for coupling the laser beam emitted by the laser diode 2 in the optical fiber 3.

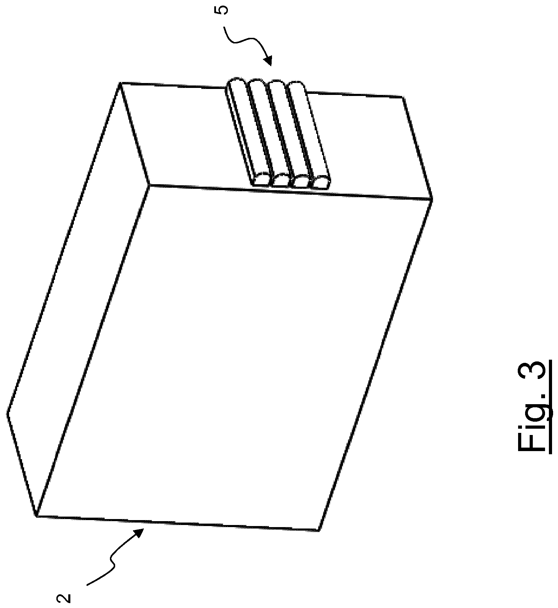

According to embodiments of the present invention, the coupling optics 4 comprises a first set of optical elements 5 in the proximity of the laser diode 2, suitable for reducing the divergence of the beam at least within the acceptance limit of the optical fiber. In particular, the first optical elements 5 allow the divergence of the beam along the fast axis to be reduced and make this divergence at least comparable to the natural divergence of the beam along the slow axis. The first set of optical elements 5 may comprise one or more fast-axis collimation lenses (indicated here below, for simplicity, as "collimation lenses") located in the proximity of the laser diode 2. The collimation lenses are preferably so-called FAC (Fast Axis Collimation) lenses, in particular they are cylindrical FAC lenses. Such collimation lenses have focal power along the fast axis of the laser diode 2. If the laser diode 2 is formed by a laser stack, the collimation lenses are preferably one in number for each laser bar included in the laser stack. Figure 3 schematically shows, by way of example, a laser diode 2 formed by a laser stack, composed of four laser bars, and four collimation lenses 5. The collimation lenses 5 shown in Figure 3, suitable for use in combination with a laser stack such as that shown in the same Figure, have a length slightly greater than the length of the single laser bar and height about equal to the spatial distance between the laser bars. For example, FAC collimation lenses produced by the company LIMO Lissotschenko Mikrooptik GmbH, with focal length of about 0.8 - 0.9 mm, may be used. The focal length of the collimation lenses 5 for a laser stack such as that schematically shown in Figure 3 is comprised between a few hundred µm and about 2 mm. This focal length is such that each collimation lens 5 is able to intercept the beam emitted by a respective laser bar, reducing its divergence from the original value to a value comparable to that of the slow axis or lower. Typically, the slow axis has a natural divergence of between about 6° FWHM and about 14° FWHM. The collimation lenses 5, according to the present invention, bring the divergence from the initial 30° - 40° FWHM to a value equal to about 1° FWHM or less of residual divergence.

It should be noted that the first set of optical elements 5 is optional for embodiments comprising a laser diode 2 and a liquid optical fiber 3 such that the laser beam emitted by the laser diode 2 has a natural divergence which does not exceed the acceptance of the optical fiber 3.

The system 1 preferably comprises a second set of optical elements 6 suitable for focusing the beam in the optical fiber 3. The second set of optical elements 6 preferably comprises at least one lens for focusing the laser beam, arranged in between the first set of optical elements 5 and the optical fiber 3, as shown in Figure 1.

Preferably, the second set of optical elements 6 comprises an aspherical focusing lens. According to the present invention, the choice of the aspherical focusing lens depends on the characteristics of the laser stack, in particular on the total size of the starting beam and the fiber in which the laser beam is to be coupled. The diameter of the lens, which must be sufficiently large, depends on the total size of the starting beam, while the smaller the diameter of the core of the fiber in which the beam is to be coupled, the smaller the focal length. For example, the aspherical lens may have a diameter of about 25 mm and a focal length equal to 20 mm. Other aspherical lenses which may be used range from lenses with a diameter of about 15 mm and focal length of about 15 mm, to lenses with a diameter of about 30 mm and focal length equal to about 25-30 mm. The use of an aspherical lens offers a number of advantages. First of all, an aspherical lens is able to focus effectively even the most peripheral beams, i.e. the beams impinging on the lens itself at the edge. These beams in fact are focused together with the more central beams with minimal distortion. In addition, the aspherical lens has a high numerical aperture, i.e. it has a wide diameter compared to the focal length. This wide diameter is advantageous when the laser diode 2 is a laser stack comprising several laser bars spaced, for example, at about 1.6 mm or 1.8 mm from each other so that the beam reaches a height of more than 15-20 mm and a width of more than 10 mm. The reduced focal length advantageously allows focusing of the beam on a relatively small size, i.e. about 2-4 mm, taking advantage of the wide acceptance of the optical fiber 3. In this way it is in fact possible to use liquid optical fibers with a relatively small diameter, for example comprised between about 3 mm and about 5 mm, the transmitted beam thereof being able to be more easily managed at the output of the optical fiber.

Alternatively, the second set of optical elements 6 may comprise a convex lens of the spherical type. In particular, a convex lens of the spherical type may be used in the second set of optical elements 6 in cases where there is no need to use a liquid optical fiber with a particularly small diameter. In these cases the use of a spherical lens is particularly advantageous since such a lens is simple and low cost.

In addition or alternatively, the second set of optical elements 6 may comprise two or more cylindrical lenses, with a different focal power along the main axes of the laser beam. This advantageously allows focusing of the beam along the main axes in a different way, for example if the dimensions or the divergences along the axes are very different from one another.

According to other embodiments of the present invention, the second set of optical elements 6 may comprise a combination of aspherical and/or spherical and/or cylindrical lenses. For example, the second set of optical elements 6 may comprise cylindrical lenses in order to reduce the natural divergence of the slow axis and an aspherical lens for focusing; or the second set of optical elements 6 may comprise a single spherical lens or a spherical lens in combination with two cylindrical lenses for coupling the beam in a liquid optical fiber 3 with a diameter for example of about 2-3mm.

Finally, in addition or as an alternative to the lenses, the second set of optical elements 6 may comprise one or more mirrors and/or prisms. For example, the second set of optical elements 6 may comprise a concave mirror with a focal length equal to that of the aforementioned spherical convex lens. The use of mirrors in addition or as an alternative to the lenses may be useful when for example there are mechanical constraints which must be satisfied, or when the transmissivity of a lens is not sufficiently high and may cause a loss of efficiency. Furthermore, the use of mirrors is useful in the case where two or more laser diodes are to be used, for example coupled in terms of polarization or wavelength, in order to couple a larger quantity of optical power in the optical fiber.

In the case where there is the need to couple in the optical fiber 3 laser diodes having different wavelengths, the second set of optical elements 6 may comprise an optics of the achromatic type. As is known, an achromatic optics typically consists of two or three lenses cemented together and is able to correct both the spherical aberration and the so-called chromatic aberration, that is, the different focusing of beams which have different wavelengths. The possibility of launching in the optical fiber laser beams of varying wavelength (typical wavelengths are for example 760 nm, 808 nm, 980 nm and 1064 nm), results in a multi-wavelength beam at the output, which may be advantageous above all in aesthetic-medical applications. Furthermore, as already mentioned here above, using laser diodes with different wavelengths, in combination with dichroic optics, enables more power to be coupled in the optical fiber.

According to embodiments of the present invention, the numerical aperture of the laser beam input into the optical fiber 3 is lower than the maximum acceptance of the fiber 3. More particularly, the numerical aperture of the beam input into the fiber 3 is preferably lower than 2/3 of the maximum acceptance of the fiber. The numerical aperture of the input beam depends on the optical elements 5,6 which may reduce the divergence of the beam and focus it for input into the optical fiber, and it is equal to the transverse half-dimension of the beam divided by the focal length of the focusing system.

If, for example, we consider a liquid optical fiber 3 with a diameter of 3 mm and numerical aperture of 0.54, according to the present invention, the laser beam that enters this fiber 3 has a numerical aperture of less than 0.36. In fact, for example, along the slow axis the beam is about 10 mm wide (i.e. corresponding to the width of the bar, unless the beam divergence) and the focal length of the optical focusing system is equal to about 20 mm, so that the numerical aperture is equal to about 0.25. Along the fast axis, if the laser diode comprises, for example, 8 laser bars spaced at about 1.8 mm, the half-height is equal to about 6.3 mm; considering a focal length of about 20 mm, the numerical aperture is equal to about 0.31.

The feature whereby the numerical aperture of the laser beam input into the optical fiber is smaller than the maximum acceptance of the fiber also offers a number of advantages. As is known, the total internal reflection angle which ensures the transmission of the radiation in the optical fiber changes at the curvatures of the fiber. In particular, at accentuated curvatures, the fiber may not be able to guide the radiation in an effective manner because some rays, impinging on the fiber at an angle greater than the limit angle altered by the curvature, may escape out from the fiber core. The rays escaping out from the core are absorbed by the outer coating of the fiber and cause overheating. Such overheating is all the more damaging the greater the power transported in the fiber. Advantageously, the present invention allows the numerical aperture of the input beam to be kept below the maximum acceptance of the fiber and therefore the rays of the input beam may be prevented from exiting the core at a curvature of the fiber.

The system for coupling a laser diode, in particular a medium-high power laser diode, in an optical guide described here above therefore offers several advantages.

In a liquid optical fiber the core has a diameter which is much greater than that of any glass optical fiber and also the numerical aperture is much greater. These properties give the liquid optical fiber a sufficiently high BPP so as to be able to effectively couple the laser beam emitted by a medium-high power laser diode. In particular, the core of the liquid optical fiber has a diameter comparable to that of a fiber bundle but, unlike the latter which comprises a plurality of optical fibers arranged side-by-side and intervalled by empty spaces which do not guide the radiation, it is perfectly homogeneous, so as to limit the losses. As a result of the homogeneity of the core it is possible to obtain at the output from the fiber a beam which has a homogeneous profile and is therefore suitable for various applications in the industrial and aesthetic-medical field, such as for example the heat treatment of materials, the activation of heat-sensitive materials, laser hair removal, vascular and skin treatments. In particular, the system described above may advantageously be used in an apparatus for laser hair removal where there is the need to arrange the laser diode in a remote position with respect to the application area, thus ensuring a high homogeneity of the laser beam in the application area .

The optics described above for the focusing system are commonly available commercially and easily manageable. They also have a low cost. The described system is therefore inexpensive and robust.

Finally, the inventors have carried out a number of experimental tests which have shown that the coupling in an optical guide of a medium-high power laser diode by means of the described system allows achieving a transmission efficiency even greater than 95%, thus significantly limiting losses.

## Claims

1. System (1) for coupling a laser beam from a medium-high power laser diode device (2) in an optical guide, said system (1) comprising :
said laser diode device (2),
a liquid optical fiber (3), and
coupling optics (4) arranged in between said laser diode device (2) and said liquid optical fiber (3) so as to couple said laser beam emitted by the laser diode device (2) in said liquid optical fiber (3), wherein said medium-high power laser diode device (2) comprises at least two laser bars arranged in a vertical stack, each of said at least two laser bars comprising a plurality of laser emitters arranged side by side along a direction,
**characterized in that**
the optical fiber (3) comprises a liquid core (31) and a cladding (32) of polymeric material, and wherein the core of said optical fiber (3) has a diameter of between about 2 mm and about 8 mm and said optical fiber (3) has a numerical aperture of between about 0.3 and about 0.65.

2. System (1) according to claim 1, wherein said medium-high power laser diode device (2) is suitable for emitting a radiation having an average power comprised between about 50 W and about 2000 W in CW mode.

3. System (1) according to claim 1, wherein said medium-high power laser diode device (2) is suitable for emitting a radiation having a peak power comprised between about 500 W and about 8000 W in QCW mode.

4. System (1) according to claim 1, wherein the spatial density of each of said at least two laser bars varies from a minimum of about 20% to a maximum of about 90%.

5. System (1) according to any one of the preceding claims, wherein the optical fiber (3) has a core diameter of between about 3 mm and about 5 mm.

6. System (1) according to any one of the preceding claims, wherein said liquid core (31) is sealed by means of glass bars (35), said glass bars being coated by said polymeric material of the cladding (32), said polymeric material being in turn coated by a metal coating (34) at one end of said optical fiber (3), wherein a terminal part of a glass bar (35) at said end protrudes lengthwise with respect to said metal coating (34).

7. System (1) according to claim 6, wherein said terminal part of said glass bar (35) at said end of the optical fiber (3) protrudes with respect to said metal coating (34) by a length of between about 3 mm and about 10 mm.

8. System (1) according to any one of the preceding claims, wherein said coupling optics (4) comprises cylindrical fast-axis collimation lenses in the proximity of said laser diode device (2).

9. System (1) according to any one of the preceding claims, wherein said coupling optics (4) comprises an aspherical lens and/or a convex lens of the spherical type and/or at least two cylindrical lenses.

10. System (1) according to any one of the preceding claims, wherein said coupling optics (4) comprises one or more mirrors and/or prisms.

11. System (1) according to any one of the preceding claims, wherein said coupling optics (4) comprises optics of the achromatic type.

## Patentansprüche

1. System (1) zum Einkoppeln eines Laserstrahls von einer Laserdiode (2) mittel-hoher Leistung in einen Lichtleiter, wobei das System (1) umfasst:
die Laserdiode (2),
einen flüssigen Lichtleiter (3) und
eine Koppeloptik (4), die zwischen der Laserdiode (2) und dem flüssigen Lichtleiter (3) angeordnet ist, um den von der Laserdiode (2) abgestrahlten Laserstrahl in den flüssigen Lichtleiter (3) einzukoppeln,
wobei die Laserdiode (2) mittel-hoher Leistung mindestens zwei Laserstäbe umfasst, die in einem vertikalen Stapel angeordnet sind,
wobei jede von diesen mindestens zwei Laserstäben eine Vielzahl von Laserstrahlern umfasst, die nebeneinander entlang einer Richtung angeordnet sind,
**dadurch gekennzeichnet, dass**
der Lichtleiter (3) einen flüssigen Kern (31) und eine Umhüllung (32) aus Polymer-Material umfasst und
dass der Kern des Lichtleiters (3) einen Durchmesser von zwischen etwa 2 mm und etwa 8 mm hat und der Lichtleiter eine numerische Apertur von zwischen etwa 0,3 und etwa 0,65 hat.

2. System (1) nach Anspruch 1,
wobei die Laserdiode (2) mittel-hoher Leistung zum Ausstrahlen einer Strahlung geeignet ist mit einer durchschnittlichen Leistung, die zwischen etwa 50 W und etwa 2000 W im CW-Modus liegt.

3. System (1) nach Anspruch 1,
wobei die Laserdiode (2) mittel-hoher Leistung zum Ausstrahlen einer Strahlung geeignet ist mit einer Spitzenleistung, die zwischen etwa 500 W und etwa 8000 W im QCW-Modus liegt.

4. System (1) nach Anspruch 1,
wobei die räumliche Dichte jedes der mindestens zwei Laserstäbe variiert von einem Minimum von etwa 20 % bis zu einem Maximum von etwa 90 %.

5. System (1) nach einem der vorhergehenden Ansprüche,
wobei der Lichtleiter (3) einen Kerndurchmesser zwischen etwa 3 mm und etwa 5 mm hat.

6. System (1) nach einem der vorhergehenden Ansprüche,
wobei der flüssige Kern (31) mittels Glasstäben (35) abgedichtet ist, wobei die Glasstäbe mit dem Polymer-Material der Umhüllung (32) beschichtet sind, wobei das Polymer-Material wiederum mit einer Metallbeschichtung (34) an einem Ende der optischen Faser (3) beschichtet ist, wobei ein Anschlussteil eines Glasstabs (35) an diesem Ende in Längsrichtung bezüglich der Metallbeschichtung (34) vorsteht.

7. System (1) nach Anspruch 6,
wobei das Anschlussteil des Glasstabs (35) an diesem Ende der optischen Faser (3) in Bezug auf die Metallbeschichtung (34) um eine Länge zwischen etwa 3 mm und etwa 10 mm vorsteht.

8. System (1) nach einem der vorhergehenden Ansprüche,
wobei die Kopplungsoptik (4) zylindrische Festachsen-Kollimationslinsen in der Nähe dieser Laserdiode (2) umfasst.

9. System (1) nach einem der vorhergehenden Ansprüche,
wobei die Kopplungsoptik (4) eine asphärische Linse und/oder eine konvexe Linse des kugelförmigen Typs und/oder mindestens zwei zylindrische Linsen umfasst.

10. System (1) nach einem der vorhergehenden Ansprüche,
wobei die Kopplungsoptik (4) einen oder mehrere Spiegel und/oder Prismen umfasst.

11. System (1) nach einem der vorangehenden Ansprüche,
wobei die Kopplungsoptik (4) eine Optik des achromatischen Typs umfasst.

## Revendications

1. Système (1) de couplage d'un faisceau laser à partir d'un dispositif à diodes laser de puissance moyenne à élevée (2) dans un guide d'onde optique, ledit système (1) comprenant :
ledit dispositif à diodes laser (2),
une fibre optique liquide (3), et
une optique de couplage (4) agencée entre ledit dispositif à diodes laser (2) et ladite fibre optique liquide (3) de sorte à coupler ledit faisceau laser émis par le dispositif à diodes laser (2) dans ladite fibre optique liquide (3), dans lequel ledit dispositif à diodes laser de puissance moyenne à élevée (2) comprend au moins deux barres laser agencées en une pile verticale, chacune desdites au moins deux barres laser comprenant une pluralité d'émetteurs laser agencés côte à côte le long d'une direction,
**caractérisé en ce que**
la fibre optique (3) comprend une âme liquide (31) et une gaine (32) de matériau polymère, et dans lequel l'âme de ladite fibre optique (3) a un diamètre d'environ 2 mm et d'environ 8 mm et ladite fibre optique (3) a une ouverture numérique comprise entre environ 0,3 et environ 0,65.

2. Système (1) selon la revendication 1, dans lequel ledit dispositif à diodes laser de puissance moyenne à élevée (2) est capable d'émettre un rayonnement ayant une puissance moyenne comprise entre environ 50 W et environ 2000 W en mode CW.

3. Système (1) selon la revendication 1, dans lequel ledit dispositif à diodes laser de puissance moyenne à élevée (2) est capable d'émettre un rayonnement ayant une puissance crête comprise entre environ 500 W et environ 8000 W en mode QCW.

4. Système (1) selon la revendication 1, dans lequel la densité spatiale de chacune desdites au moins deux barres laser varie d'un minimum d'environ 20 % à un maximum d'environ 90 %.

5. Système (1) selon l'une quelconque des revendications précédentes, dans lequel la fibre optique (3) a un diamètre d'âme compris entre environ 3 mm et environ 5 mm.

6. Système (1) selon l'une quelconque des revendications précédentes, dans lequel ladite âme liquide (31) est scellée au moyen de barres de verre (35), lesdites barres de verre étant revêtues par ledit matériau polymère de la gaine (32), ledit matériau polymère étant à son tour revêtu par un revêtement métallique (34) à une extrémité de ladite fibre optique (3), dans lequel une partie terminale d'une barre de verre (35) à ladite extrémité fait saillie dans le sens de la longueur par rapport audit revêtement métallique (34).

7. Système (1) selon la revendication 6, dans lequel ladite partie terminale de ladite barre de verre (35) à ladite extrémité de la fibre optique (3) fait saillie par rapport audit revêtement métallique (34) d'une longueur comprise entre environ 3 mm et environ 10 mm.

8. Système (1) selon l'une quelconque des revendications précédentes, dans lequel ladite optique de couplage (4) comprend des lentilles de collimation à axe rapide cylindriques à proximité dudit dispositif à diodes laser (2).

9. Système (1) selon l'une quelconque des revendications précédentes, dans lequel ladite optique de couplage (4) comprend une lentille asphérique et/ou une lentille convexe du type sphérique et/ou au moins deux lentilles cylindriques.

10. Système (1) selon l'une quelconque des revendications précédentes, dans lequel ladite optique de couplage (4) comprend un ou plusieurs miroirs et/ou prismes.

11. Système (1) selon l'une quelconque des revendications précédentes, dans lequel ladite optique de couplage (4) comprend une optique du type achromatique.
